# EUROPEAN PATENT APPLICATION

(11) **EP 4 029 896 A1**
(43) Date of publication of application: **20.07.2022**
(21) Application number: 20862262.1
(22) Date of filing: 02.09.2020
(51) Int. Cl.: C08G 59/40, C08G 73/06, C08K 3/013, C08L 63/00, C08L 79/04, H01L 21/56, H01L 23/29, H01L 23/31

(54) **CURABLE RESIN COMPOSITION**

(30) Priority: 09.09.2019 JP 2019163992
(71) Applicant: ADEKA CORPORATION, Arakawa-ku Tokyo 116-8554 (JP)
(72) Inventor: OTA, Keisuke, Kuki-shi, Saitama 346-0101 (JP); HIRAYAMA, Kohei, Kuki-shi, Saitama 346-0101 (JP); YAMADA, Shinsuke, Kuki-shi, Saitama 346-0101 (JP); OGAWA, Ryo, Kuki-shi, Saitama 346-0101 (JP)
(74) Representative: Forstmeyer, Dietmar
(86) International application number: PCT/JP2020/033291
(87) International publication number: WO 2021/049390

(57) **Abstract**

A curable resin composition having fast-curing properties, high heat resistance, and excellent infiltration properties. The composition contains: (A) a cyanate ester resin, (B) an epoxy resin, (C) a latent curing agent, and (D) an inorganic pigment containing at least one metal selected from titanium, iron, copper, chromium, zirconium, calcium, manganese, and zinc. The inorganic pigment (D) preferably has a primary particle size of 5 to 150 nm. The inorganic pigment (D) is preferably present in an amount of 0.01 to 10 parts by mass per 100 parts by mass of the sum of the cyanate ester resin (A) and the epoxy resin (B).

## Description

### Technical Field

This invention relates to a curable resin composition, more particularly a curable resin composition containing a cyanate ester resin, an epoxy resin, a latent curing agent, and an inorganic pigment containing at least one metal selected from titanium, iron, copper, chromium, zirconium, calcium, manganese, and zinc.

### Background Art

Epoxy resins are widely used in industry in the fields such as coatings, adhesives, and various molding materials. When existing epoxy resins are simply used either singly or in combination, the properties thereof may be insufficient. For such cases, a cyanate-epoxy composite resin composition composed of an epoxy resin and a cyanate ester resin is frequently used as a useful material because of its fast-curing properties and high heat resistance (see, e.g., patent literatures 1 to 5 listed below).

A cyanate-epoxy composite resin composition is considered also suited for use as an underfill material for its properties. Underfill materials are usually colored with a pigment to improve visibility, and carbon black is often used as a blackening agent. However, addition of carbon black to a cyanate-epoxy composite resin composition gives rise to the problem of considerable reduction of infiltration properties.

Patent literature 6 discloses a composition containing titanium black; however, Patent literature 6 has no mention of application to a cyanate-epoxy composite resin composition nor suggests the improving effect on infiltration properties.

### Citation List

### Patent Literature

Patent literature 1: JP 2001-302767A
Patent literature 2: JP S60-250026A
Patent literature 3: US 6342577
Patent literature 4: US 9601401
Patent literature 5: US 9382459
Patent literature 6: JP 2015-7729A

### Summary of Invention

An object of the invention is to provide a curable resin composition that cures rapidly to provide a highly heat-resistant cured product and exhibits excellent infiltration properties.

As a result of extensive investigations, the inventors have found that a curable resin composition containing a cyanate ester resin, an epoxy resin, a latent curing agent, and a specific inorganic pigment accomplishes the above object and thus reached the present invention.

The invention provides a curable resin composition containing (A) a cyanate ester resin, (B) an epoxy resin, (C) a latent curing agent, and (D) an inorganic pigment containing at least one metal selected from titanium, iron, copper, chromium, zirconium, calcium, manganese, and zinc.

### Description of Embodiments

The curable resin composition of the invention will be described hereunder.

The cyanate ester resin that can be used in the invention as component (A) is not particularly limited in molecular structure, molecular weight, and so on as long as it has at least two cyanate groups.

The cyanate ester resin is exemplified by compounds represented by formula (1) below, compounds represented by formula (2) below, and prepolymers of the compound (1) and/or the compound (2). The term "prepolymer" as used herein refers to a compound having a triazine ring formed by allowing cyanate groups to trimerize.

[Chem. 1]

NC-O-A¹⁻Y¹⁻A²⁻O-CN (1)

wherein Y¹ represents a divalent hydrocarbon group optionally substituted with a fluorine atom or a cyanate group, -O-, -S-, or a single bond; and A¹ and A² each independently represent a phenylene group optionally substituted with an alkyl group having 1 to 4 carbon atoms. 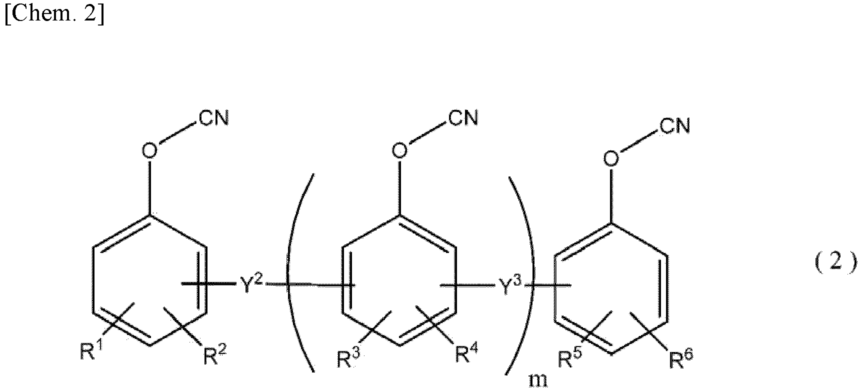 wherein m represents an integer of 1 or greater; Y² and Y³ each independently represent a divalent hydrocarbon group optionally substituted with a fluorine atom or a cyanate group; and R¹ R², R³, R⁴, R⁵, and R⁶ each independently represent a hydrogen atom or an alkyl group having 1 to 4 carbon atoms.

The divalent hydrocarbon groups as represented by Y¹ in formula (1) and Y² and Y³ in formula (2) are preferably those having 1 to 20 carbon atoms, such as C1-C20 alkyl, C3-C20 cycloalkyl, C6-C30 aryl, or a combination thereof.

Examples of Y¹ in formula (1) and Y² and Y³ in formula (2) include those represented by formulae (Y-1) through (Y-9): 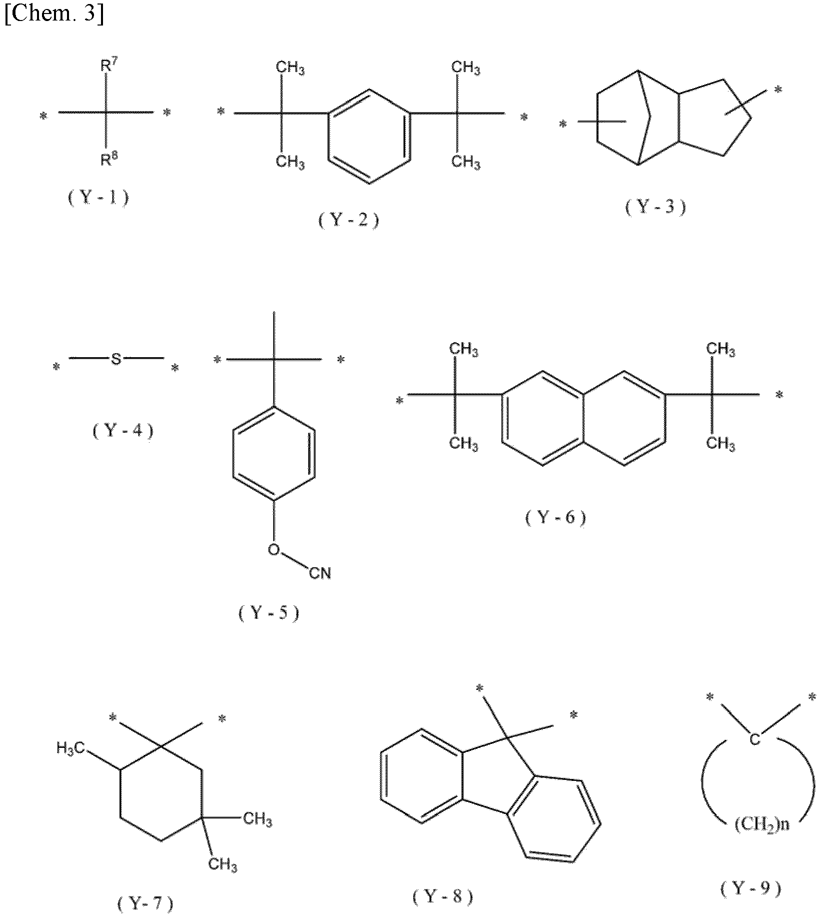 wherein n represents an integer of 4 to 12; R⁷ and R⁸ each independently represent a hydrogen atom or a methyl group optionally substituted with a fluorine atom; and ^{∗} represents a bond.

Commercially available cyanate ester resins can be used, and examples thereof include, but are not limited to, Cyanate LeCy, PT-15, PT30, and PT-60 available from Lonza; L-10, XU366, XU371, and XU378 from Huntsman; and CA200 from Mitsubishi Gas Chemical.

The cyanate ester resins may be used either individually or in combination of two or more thereof.

Preferred of the above-described cyanate ester resins are bisphenol, biphenyl, and novolak phenol types. Particularly preferred are bisphenol cyanate ester resins, including bisphenol A, bisphenol E, and bisphenol F types.

The epoxy resin that can be used as component (B) is not particularly limited in molecular structure, molecular weight, and so on as long as it has at least two epoxy groups per molecule.

Examples of useful epoxy resins include polyglycidyl ether compounds of mononuclear polyhydric phenol compounds, such as hydroquinone, resorcin, pyrocatechol, and phlorogluccinol; polyglycidyl ether compounds of polynuclear polyhydric phenol compounds, such as dihydroxynaphthalene, biphenol, methylenebisphenol(bisphenol F), methylene bis(orthocresol), ethylidene bisphenol, isopropylidene bisphenol (bisphenol A), isopropylidene bis(orthocresol), tetrabromobisphenol A, 1,3-bis(4-hydroxycumylbenzene), 1,4-bis(4-hydroxycumylbenzene), 1,1,3-tris(4-hydroxyphenyl)butane, 1,1,2,2-tetra(4-hydroxyphenyl)ethane, thiobisphenol, sulfobisphenol, oxybisphenol, phenol novolak, orthocresol novolak, ethylphenol novolak, butylphenol novolak, octylphenol novolak, resorcin novolak, and terpenephenol; polyglycidyl ether compounds of polyhydric alcohols, such as ethylene glycol, propylene glycol, butylene glycol, hexanediol, polyethylene glycol, polypropylene glycol, thioglycol, dicyclopentadiene dimethanol, 2,2-bis(4-hydroxycyclohexyl)propane (hydrogenated bisphenol A), glycerol, trimethylolpropane, pentaerythritol, sorbitol, and bisphenol A-alkylene oxide adducts; glycidyl esters of aliphatic, aromatic, or alicyclic polybasic acids, such as maleic acid, fumaric acid, itaconic acid, succinic acid, glutaric acid, suberic acid, adipic acid, azelaic acid, sebacic acid, dimer acid, trimer acid, phthalic acid, isophthalic acid, terephthalic acid, trimellitic acid, trimeric acid, pyromellitic acid, tetrahydrophthalic acid, and endomethylene tetrahydrophthalic acid; homopolymers or copolymers of glycidyl methacrylate; epoxy compounds having a glycidylamino group, such as N,N-diglycidylaniline, bis(4-(N-methyl-N-glycidylamino)phenyl)methane, diglycidyl orthotoluidine, N,N-bis(2,3-epoxypropyl)-4-(2,3-epoxypropoxy)-2-methylaniline, N,N-bis(2,3-epoxypropyl)-4-(2,3-epoxypropoxy)aniline, and N,N,N',N'-tetra(2,3-epoxypropyl)-4,4-diaminodiphenylmethane; epoxidized compounds of cyclic olefin compounds, such as vinylcyclohexene diepoxide, cyclopentanediene diepoxide, 3,4-epoxycyclohexylmethyl-3,4-epoxycyclohexane carboxylate, 3,4-epoxy-6-methylcyclohexylmethyl-6-methylcyclohexane carboxylate, and bis(3,4-epoxy-6-methylcyclohexylmethyl) adipate; epoxidized conjugated diene polymers, such as epoxidized polybutadiene and epoxidized styrene-butadiene copolymers; and heterocyclic compounds, such as triglycidyl isocyanurate. These epoxy resins may be internally crosslinked by an isocyanate-terminated prepolymer or may have their molecular weight increased by using polyhydric active hydrogen compounds (such as polyhydric phenols, polyamines, carbonyl-containing compounds, and polyphosphoric esters).

These epoxy resins may be used either individually or in combination of two or more thereof.

Preferred of the above-described epoxy resins are polyglycidyl ether compounds of polynuclear polyhydric phenol compounds, epoxy compounds having a glycidylamino group, and polyglycidyl ether compounds of dicyclopentadienedimethanol.

In order to produce cured products with excellent physical properties, the content of the epoxy resin (B) in the curable resin composition is preferably 20 to 200 parts by mass, more preferably 30 to 100 parts by mass, per 100 parts by mass of the cyanate ester resin (A).

Examples of the latent curing agent (C) used in the invention include dibasic acid dihydrazides, such as oxalic, malonic, succinic, glutaric, adipic, suberic, azelaic, sebacic, and phthalic dihydrazide; guanidine compounds, such as dicyandiamide, benzoguanamine, and acetoguanamine; melamine; and modified amines, such as dehydration condensation products between an amine and a carboxylic acid, amine-epoxy adducts, amine-isocyanate adducts, amine-Michael adducts, amine-Mannich reaction products, amine-urea condensates, and amine-ketone condensates.

Preferred of the above-described latent curing agents are active hydrogen-containing amine compounds. Particularly preferred are (C-1) modified amines obtained by the reaction between an amine compound having one or more active hydrogens and an epoxy compound, (C-2) modified amines obtained by the reaction between an amine compound having one or more active hydrogens and an isocyanate compound, (C-3) modified amines obtained by the reaction between an amine compound having one or more active hydrogens, an epoxy compound, and an isocyanate compound, and (C-4) latent curing agents containing at least one modified amine selected from (C-1), (C-2), and (C-3) and a phenol resin.

Examples of the amine compound having one or more active hydrogens include alkylenediamines, such as ethylenediamine, 1,2-diaminopropane, 1,3-diaminopropane, 1,3-diaminobutane, 1,4-diaminobutane, and hexamethylenediamine; polyalkylpolyamines, such as diethylenetriamine, triethylenetriamine, and tetraethylenepentamine; alicyclic polyamines, such as 1,4-diaminocyclohexane, 1,3-diaminocyclohexane, 1,3-diaminomethylcyclohexane, 1,2-diaminocyclohexane, 1,4-diamino-3,6-diethylcyclohexane, 4,4'-diaminodicyclohexylmethane, 1,3-bis(aminomethyl)cyclohexane, 1,4-bis(aminomethyl)cyclohexane, 4,4'-diaminodicyclohexylpropane, bis(4-aminocyclohexyl)sulfone, 4,4'-diaminodicyclohexyl ether, 2,2'-dimethyl-4,4'-diaminodicyclohexylmethane, isophoronediamine, and norbornenediamine; aromatic polyamines, such as m-xylylenediamine, diaminodiphenylmethane, diaminodiphenylsulfone, diethyltoluenediamine, 1-methyl-3,5-diethyl-2,4-diaminobenzene, 1-methyl-3,5-diethyl-2,6-diaminobenzene, 1,3,5-triethyl-2,6-diaminobenzene, 3,3'-diethyl-4,4'-diaminodiphenylmethane, and 3,5,3',5'-tetramethyl-4,4'-diaminodiphenylmethane; guanamines, such as benzoguanamine and acetoguanamine; imidazoles, such as 2-methylimidazole, 2-ethyl-4-methylimidazole, 2-isopropylimidazole, 2-undecylimidazole, 2-heptadecylimidazole, 2-phenylimidazole, 2-phenyl-4-methylimidazole, and 2-aminopropylimidazole; dihydrazides, such as oxalic dihydrazide, malonic dihydrazide, succinic dihydrazide, glutaric dihydrazide, adipic dihydrazide, suberic dihydrazide, azelaic dihydrazide, sebacic dihydrazide, and phthalic dihydrazide; N,N-dimethylaminoethylamine, N,N-diethylaminoethylamine, N,N-diisopropylaminoethylamine, N,N-diallylaminoethylamine, N,N-benzylmethylaminoethylamine, N,N-dibenzylaminoethylamine, N,N-cyclohexylmethylaminoethylamine, N,N-dicyclohexylaminoethylamine, N-(2-aminoethyl)pyrrolidine, N-(2-aminoethyl)piperidine, N-(2-aminoethyl)morpholine, N-(2-aminoethyl)piperazine, N-(2-aminoethyl)-N'-methylpiperazine, N,N-dimethylaminopropylamine, N,N-diethylaminopropylamine, N,N-diisopropylaminopropylamine, N,N-diallylaminopropylamine, N,N-benzylmethylaminopropylamine, N,N-dibenzylaminopropylamine, N,N-cyclohexylmethylaminopropylamine, N,N-dicyclohexylaminopropylamine, N-(3-aminopropyl)pyrrolidine, N-(3-aminopropyl)piperidine, N-(3-aminopropyl)morpholine, N-(3-aminopropyl)piperazine, N-(3-aminopropyl)-N'-methylpiperidine, 4-(N,N-dimethylamino)benzylamine, 4-(N,N-diethylamino)benzylamine, 4-(N,N-diisopropylamino)benzylamine, N,N-dimethylisophoronediamine, N,N-dimethylbisaminocyclohexane, N,N,N'-trimethylethylenediamine, N'-ethyl-N,N-dimethylpropanediamine, N,N,N'-trimethylethylenediamine, N'-ethyl-N,N-dimethylpropanediamine, N'-ethyl-N,N-dibenzylaminopropylamine, N,N-(bisaminopropyl)-N-methylamine, N,N-bisaminopropylethylamine, N,N-bisaminopropylpropylamine, N,N-bisaminopropylbutylamine, N,N-bisaminopropylpentylamine, N,N-bisaminopropylhexylamine, N,N-bisaminopropyl-2-ethylhexylamine, N,N-bisaminopropylcyclohexylamine, N,N-bisaminopropylbenzylamine, N,N-bisaminopropylallylamine, bis[3-(N,N-dimethyglaminopropyl)]amine, bis[3-(N,N-diethylaminopropyl)]amine, bis[3-(N,N-diisopropylaminopropyl)]amine, and bis[3-(N,N-dibutylaminopropyl)]amine.

Examples of the epoxy compound include polyglycidyl ether compounds of mononuclear polyhydric phenol compounds, such as hydroquinone, resorcin, pyrocatechol, and phloroglucinol; polyglycidyl ether compounds of polynuclear polyhydric phenol compounds, such as dihydroxynaphthalene, biphenol, methylenebisphenol(bisphenol F), methylene bis(orthocresol), ethylidene bisphenol, isopropylidene bisphenol (bisphenol A), isopropylidene bis(orthocresol), tetrabromobisphenol A, 1,3-bis(4-hydroxycumylbenzene), 1,4-bis(4-hydroxycumylbenzene), 1,1,3-tris(4-hydroxyphenyl)butane, 1,1,2,2-tetra(4-hydroxyphenyl)ethane, thiobisphenol, sulfonylbisphenol, oxybisphenol, phenol novolak, orthocresol novolak, ethylphenol novolak, butylphenol novolak, octylphenol novolak, resorcin novolak, and terpenephenol; polyglycidyl ether compounds of polyhydric alcohols, such as ethylene glycol, propylene glycol, butylene glycol, hexanediol, polyglycol, thiodiglycol, glycerol, trimethylolpropane, pentaerythritol, sorbitol, and bisphenol A-alkylene oxide adducts; glycidyl esters of aliphatic, aromatic, or alicyclic polybasic acids, such as maleic acid, fumaric acid, itaconic acid, succinic acid, glutaric acid, suberic acid, adipic acid, azelaic acid, sebacic acid, dimer acid, trimer acid, phthalic acid, isophthalic acid, terephthalic acid, trimellitic acid, trimeric acid, pyromellitic acid, tetrahydrophthalic acid, hexahydrophthalic acid, and endomethylene tetrahydrophthalic acid; homopolymers or copolymers of glycidyl methacrylate; epoxy compounds having a glycidylamino group, such as N,N-diglycidylaniline, bis(4-(N-methyl-N-glycidylamino)phenyl)methane, and diglycidyl orthotoluidine; epoxidized compounds of cyclic olefin compounds, such as vinylcyclohexene diepoxide, dicyclopentanediene diepoxide, 3,4-epoxycyclohexylmethyl-3,4-epoxycyclohexane carboxylate, 3,4-epoxy-6-methylcyclohexylmethyl-6-methylcyclohexane carboxylate, and bis(3,4-epoxy-6-methylcyclohexylmethyl) adipate; epoxidized conjugated diene polymers, such as epoxidized polybutadiene and epoxidized styrene-butadiene copolymers; and heterocyclic compounds, such as triglycidyl isocyanurate.

Examples of the isocyanate compound include aromatic diisocyanates, such as 2,4-tolylene diisocyanate, 2,6-tolylene diisocyanate, diphenylmethane-4,4'-diisocyanate, phenylene diisocyanate, xylylene diisocyanate, tetramethylxylylene diisocyanate, 1,5-naphthylene diisocyanate, 1,5-tetrahydronaphthylene diisocyanate, 3,3'-dimethyldiphenyl-4,4'-diisocyanate, dianisidine diisocyanate, and tetramethylxylylene diisocyanate; alicyclic diisocyanates, such as isophorone diisocyanate, dicyclohexylmethane-4,4'-diisocyanate, trans-1,4-cyclohexyl diisocyanate, and norbornene diisocyanate; aliphatic diisocyanates, such as tetramethylene diisocyanate, 1,6-hexamethylene diisocyanate, 2,2,4-trimethylhexamethylene diisocyanate, 2,4,4-trimethylhexamethylene diisocyanate, and lyssine diisocyanate; isocyanurate trimers, biuret trimers, or trimethylolpropane adducts of the above recited diisocyanates; triphenylmethane triisocyanate, 1-methylbenzole-2,4,6-triisocyanate, and dimethyltriphenylmethane tetraisocyanate. These isocyanate compounds may be used in a modified form, such as carbodiimide-, isocyanurate- or biuret-modified form, or used in the form of a blocked isocyanate, in which the isocyanate compound is blocked with any of various blocking agents.

The ratio of the amount of the epoxy compound to the amount of the amine compound having one or more active hydrogens in the modified amine (C-1) is preferably such that the epoxy equivalent of the epoxy compound is 0.1 to 1.1, more preferably 0.2 to 1.0, per active hydrogen equivalent of the amine compound.

The ratio of the amount of the isocyanate compound to the amount of the amine compound having one or more active hydrogens in the modified amine (C-2) is preferably such that the isocyanate equivalent of the isocyanate compound is 0.1 to 1.1, more preferably 0.2 to 1.0, per active hydrogen equivalent of the amine compound.

The ratio of the amounts of the epoxy compound and the isocyanate compound to the amount of the amine compound having one or more active hydrogens in the modified amine (C-3) is preferably such that the total of the epoxy equivalent of the epoxy compound and the isocyanate equivalent of the isocyanate compound is 0.1 to 1.1, more preferably 0.2 to 1.0, per active hydrogen equivalent of the amine compound.

When the ratio of the amount of the epoxy compound and/or the amount of the isocyanate compound to the amount of the amine compound having one or more active hydrogens is less than the lower limit described above, the composition may have reduced storage stability. When the ratio exceeds the upper limit described above, the curability of the composition can be poor.

Use of these modified amines containing active hydrogen are particularly advantageous in that the composition exhibits excellent curing properties and that a cured product obtained therefrom has excellent physical properties.

The methods for preparing the modified amines (C-1), (C-2), and (C-3) are not particularly limited. For example, they can be prepared by allowing the reactants to react in the absence or, if necessary, presence of a solvent at from room temperature up to 140°C for 1 to 10 hours. In the preparation of the modified amine (C-3), it is preferred that the reaction between the amine compound and the epoxy compound precede the reaction with the polyisocyanate compound. When a solvent is used, the solvent may be removed after the reaction by heating under atmospheric pressure or reduced pressure. When the reaction product is solid, it may be comminuted using an apparatus such as a jet mill.

Examples of the solvent that can be used in the preparation of the modified amines include ketones, such as methyl ethyl ketone, methyl amyl ketone, diethyl ketone, acetone, methyl isobutyl ketone, propylene glycol monomethyl ether acetate, and cyclohexane; ethers, such as tetrahydrofuran, 1,2-dimethoxyethane, 1,2-diethoxyethane, and propylene glycol monomethyl ether; esters, such as ethyl acetate and n-butyl acetate; aromatic hydrocarbons, such as benzene, toluene, and xylene; halogenated aliphatic hydrocarbons, such as carbon tetrachloride, chloroform, trichloroethylene, and methylene chloride; and halogenated aromatic hydrocarbons, such as chlorobenzene.

Examples of the phenol resin used in the latent curing agent (C-4) include polyhydric phenol compounds, such as phenol novolak resins, cresol novolak resins, aromatic hydrocarbon formaldehyde resin-modified phenol resins, dicyclopentadiene-phenol adduct resins, phenol aralkyl resins (Xyloc resins), naphthol aralkyl resins, trisphenylolmethane resins, tetraphenylolethane resins, naphthol novolak resins, naphthol-phenol cocondensate novolak resins, naphthol-cresol cocondensate novolak resins, biphenyl-modified phenol resins (polyhydric phenol compounds having phenol nuclei linked by bismethylene), biphenyl-modified naphthol resins (polyhydric naphthol compounds having phenol nuclei linked by bismethylene), aminotriazine-modified phenol resins (compounds having a phenol structure, a triazine ring, and a primary amino group in the molecule), and alkoxy-containing aromatic ring-modified novolak resins (polyhydric phenol compounds having a phenol nucleus and an alkoxy-containing aromatic ring linked by formaldehyde).

The phenol resin used in the latent curing agent (C-4) preferably has a number average molecular weight of 750 to 1200 in view of good balance between storage stability and curing properties.

The amount of the phenol resin used in the latent curing agent (C-4) is preferably 10 to 100 parts by mass, more preferably 20 to 60 parts by mass, per 100 parts by mass of the total amount of the modified amine(s). With less than 10 parts of the phenol resin, sufficient curability may not be obtained. With more than 100 parts of the phenol resin, the resulting cured product may have poor physical properties.

Among the active hydrogen-containing amine type latent curing agents described above, the modified amines (C-1) are preferred.

Commercially available latent curing agents that can be used in the invention include ADEKA Hardener series EH-3636AS (dicyandiamide type), EH-4351S (dicyandiamide type), EH-5011S (imidazole type), EH-5046S (imidazole type), EH-4357S (polyamine type), EH-4358S (polyamine type), EH-5057P (polyamine type), and EH-5057PK (polyamine type), all available from ADEKA CORPORATION; Amicure PN-23 (amine adduct type), Amicure PN-40 (amine adduct type), and Amicure VDH (hydrazide type), all from Ajinomoto Finetechno Co., Ltd.; and Fujicure FXR-1020 from T&K TOKA Co., Ltd..

The content of the latent curing agent (C) in the curable resin composition is not particularly limited but is preferably 1 to 70 parts by mass, more preferably 3 to 60 parts by mass, per 100 parts by mass of the sum of the cyanate ester resin (A) and the epoxy resin (B).

If necessary, the curable resin composition of the invention may further contain a known curing accelerator. Examples of useful curing accelerators include phosphines, such as triphenylphosphine; phosphonium salts, such as tetraphenylphosphonium bromide; imidazoles, such as 2-methylimidazole, 2-phenylimidazole, 2-ethyl-4-methylimidazole, 2-undecylimidazole, and 1-cyanoethyl-2-methylimidazole; imidazole salts between the imidazole compound recited above and trimellitic acid, isocyanuric acid, boron, and so on; amines, such as benzyldimethylamine and 2,4,6-tris(dimethylaminomethyl)phenol; quaternary ammonium salts, such as trimethylammonium chloride; ureas, such as 3-(p-chlorophenyl)-1,1-dimethylurea, 3-(3,4-dichlorophenyl)-1,1-dimethylurea, 3-phenyl-1,1-dimethylurea, isophorone diisocyanate-dimethylurea, and tolylene diisocyanate-dimethylurea; and complex compounds between boron trifluoride and amines, ether compounds, and so forth. The curing accelerators may be used either individually or in combination thereof. The curing accelerator content in the curable resin composition is not particularly limited and is decided as appropriate to the intended use of the curable resin composition of the invention.

The inorganic pigment that can be used as component (D) in the invention may be any inorganic pigment containing at least one metal selected from titanium iron, copper, chromium, zirconium, calcium, manganese, and zinc and may be in the form of a complex salt containing two or more metals. Inorganic pigments which are black with high shielding power are preferred for the present invention. For example, titanium-based black pigments, such as titanium black, are suitable.

The term "titanium black" as used herein refers to black powders containing titanium oxynitride and, optionally, an oxynitride of vanadium, niobium, and the like. Titanium black is obtained by, for example, firing titanium dioxide or titanium hydroxide to which a vanadium compound may have been deposited, in the presence of a nitrogen-containing reducing agent, such as ammonia gas or amine gas, at high temperatures in a vapor phase reaction system by, for example, electric furnace processing or thermal plasma processing. Commercially available products sold as "titanium black" are also useful. These titanium black pigments may be used either individually or in combination of two or more thereof.

Examples of the commercially available titanium black include 12S, 13M, and 13M-C from Mitsubishi Materials Electronic Chemicals Co., Ltd.; and Tilack D from Ako Kasei Co., Ltd.

Useful titanium-based black pigments other than titanium black include Tipaque Black SG-101 and Tipaque Black SG-103, both from Ishihara Sangyo Kaisha, Ltd.

The inorganic pigment preferably has a primary particle size of 1 to 2000 nm, more preferably 5 to 150 nm, in terms of infiltration properties. The primary particle size can be determined through measurement by the small-angle X-ray scattering technique using, for example, an X-ray diffractometer RINTO-TTR II from Rigaku Corp. and analysis of the resulting data using analysis software NANO-Solver from Rigaku Corp. In view of light shielding properties, the inorganic pigment preferably has a BET specific surface area of 1 to 100 m²/g and a blackness (L^{∗} value) of 20 or lower.

The content of the inorganic pigment (D) in the curable resin composition is not particularly limited but is preferably 0.01 to 10 parts by mass, more preferably 0.1 to 5 parts by mass, per 100 parts by mass of the sum of the cyanate ester resin (A) and the epoxy resin (B).

If desired, the curable resin composition of the invention may contain various additives. Examples of the additives include phenol compounds, such as biphenol; reactive diluents, such as monoalkyl glycidyl ethers; nonreactive diluents (plasticizers), such as dioctyl phthalate, dibutyl phthalate, benzyl alcohol, and coal tar; silica, such as fused silica or crystalline silica; fillers, such as powders and spherized beads of aluminum oxide (alumina), magnesium oxide, zinc oxide, magnesium hydroxide, aluminum hydroxide, aluminum nitride, silicon nitride, boron nitride, zinc molybdate, calcium carbonate, silicon carbonate, calcium silicate, potassium titanate, beryllia, zirconia, zircon, fosterite, steatite, spinel, mullite, titania, and so forth, glass fiber, pulp fiber, synthetic fiber, and ceramic fiber; reinforcing materials, such as glass cloth, aramid cloth, and carbon fiber; pigments; silane coupling agents, such as γ-aminopropyltriethoxysilane, N-β-(aminoethyl)-γ-aminopropyltriethoxysilane, N-β-(aminoethyl)-N'-β-(aminoethyl)-γ-aminopropyltriethoxysilane, γ-anilinopropyltriethoxysilane, γ-glycidoxypropyltriethoxysilane, β-(3,4-epoxycyclohexyl)ethyltriethoxysilane, vinyltriethoxysilane, N-β-(N-vinylbenzylaminoethyl)-γ-aminopropyltriethoxysilane, γ-methacryloxypropyltrimethoxysilane, γ-chloropropyltrimethoxysilane, and γ-mercaptopropyltrimethoxysilane; lubricants, such as candelilla wax, carnauba wax, Japan tallow, Chinese insect wax, bees wax, lanolin, spermaceti, montan wax, petroleum wax, aliphatic waxes, aliphatic esters, aliphatic ethers, aromatic esters, and aromatic ethers; thickeners; thixotropic agents; antioxidants; light stabilizers; UV absorbers; anti-foaming agents; rust inhibitors; colloidal silica, colloidal alumina; and other commonly used additives. Tacky resins, such as xylene resins and petroleum resins, may also be used.

The curable resin composition of the invention preferably contains a filler, such as silica, in terms of adjustment of linear expansion coefficient and improvement of reliability in terms of moisture resistance. The content of the filler such as silica is not particularly limited but preferably 30 to 90 parts by mass, more preferably 40 to 80 parts by mass, per 100 parts by mass of the sum of the cyanate ester resin (A) and the epoxy resin (B).

The curable resin composition of the invention is useful in wide variety of applications, including coatings or adhesives for concrete, cement mortar, various metals, leather, glass, rubber, plastics, wood, cloth, and paper; resin materials for electronic circuit boards, such as printed wiring laminates, interlayer insulating materials for buildup circuit boards, adhesive film for buildup boards, die attaching agents, flip-chip underfills, glob-top materials, liquid sealants for TCPs, conductive adhesives, liquid crystal sealants, coverlays for flexible circuit boards, and resist inks; semiconductor sealants; optical materials, such as optical waveguides and optical films; resin casting materials; various photosemiconductor devices, such as LEDs, photo transistors, photo diodes, photo couplers, CCDs, EPROMs, and photo sensors; fiber-reinforced resin molded products, such as CFRPs; pressure-sensitive adhesives for movable labels, POS labels, self-adhesive wallpapers, self-adhesive floorings; processed papers, such as art paper, light-weight coated paper, cast-coated paper, coated paperboards, carbonless copy paper, and impregnated paper; textile treating agents, such as sizing agents, anti-fray agents, and processing agents for natural fibers, synthetic fibers, glass fiber, carbon fiber, and metal fibers; and building materials, such as sealants, cement admixtures, and waterproof materials. The curable resin composition is particularly suited for underfill applications because of its fast curing properties, high heat resistance, and excellent infiltration properties.

### Examples

The invention will now be illustrated in greater detail with reference to Examples and Comparative Examples, but it should be understood that the invention is not deemed to be limited by these examples.

### Preparation Example 1 - Synthesis of latent curing agent EH

In a flask, 201 g of 1,2-diaminopropane was placed and heated to 60°C. To the flask, 580 g of Adeka Resin EP-4100E (bisphenol A epoxy resin, from ADEKA CORPORATION; epoxy equiv. 190) was added in small portions so that the system temperature might be kept between 100° and 110°C. The epoxy equivalent of Adeka Resin EP-4100E per mole of 1,2-diaminopropane was 1.12. After completion of the addition of Adeka Resin EP-4100E, the reaction system temperature was elevated to 140°C, at which the reaction was continued for 1.5 hours to give a modified polyamine.

To 100 g of the resulting modified polyamine, 30 g of MP-800K (phenol resin from ASAHI YUKIZAI CORPORATION; softening point 100°C) was added. The solvent was removed at 180° to 190°C and 30 to 40 torr over a period of 1 hour to obtain latent curing agent EH.

### Examples 1 to 4 and Comparative Examples 1 and 2

Materials shown in Table 1 below were mixed by stirring to prepare a curable resin composition. The composition was evaluated in terms of infiltration properties, glass transition temperature (Tg), and linear expansion coefficient (α1). The formulations (parts by mass) and results of evaluation are shown in Table 1.

### Infiltration properties:

Two glass plates (50 mm × 50 mm) were stacked with an offset of 10 mm with 100 µm-thick sealing tape interposed therebetween to make an infiltration testing device having a gap of 100 µm. The testing device was put horizontally and heated to 55°C, and 0.2 ml of the curable resin composition was placed on the offset portion of the lower glass plate. The testing device was left in a horizontal position, and the infiltration time, i.e., the time required for the curable resin composition to infiltrate into the gap to a length of 20 mm from the edge of the upper glass plate was recorded. The infiltration properties were graded on the following scale.
"good" The infiltration time was 300 seconds or shorter.
"fair" The infiltration time was longer than 300 seconds and shorter than 400 seconds.
"poor" The infiltration time was 400 seconds or longer.

### Glass transition temperature (Tg):

The curable resin composition was cured by heating at 125°C for 1 hour to make a test specimen. A linear thermal expansion curve was prepared using a TMA in accordance with JIS K7197. The Tg was determined from the inflection point on the curve.

### Linear expansion coefficient α1:

The curable resin composition was cured by heating at 125°C for 1 hour to make a test specimen. A linear thermal expansion curve was prepared using a TMA in accordance with JIS K7197, from which a linear expansion coefficient α1 was obtained.

**Table 1**

| | | Example | | | | Compara. Example | |
|---|---|---|---|---|---|---|---|
| | | 1 | 2 | 3 | 4 | 1 | 2 |
| Epoxy Resin | EP-1 | 5.0 | 5.0 | 5.0 | 5.0 | 5.0 | 5.0 |
| | EP-2 | 4.0 | 4.0 | 4.0 | 4.0 | 4.0 | 4.0 |
| | EP-3 | 2.0 | 2.0 | 2.0 | 2.0 | 2.0 | 2.0 |
| Cyanate Ester Resin | CYE | 20.0 | 20.0 | 20.0 | 20.0 | 20.0 | 20.0 |
| Curing Agent | EH | 8.0 | 8.0 | 8.0 | 8.0 | 8.0 | 8.0 |
| Filler | silica | 60.0 | 60.0 | 60.0 | 60.0 | 60.0 | 60.0 |
| Blackening Agent | CB1 | | | | | 0.6 | |
| | CB2 | | | | | | 1.2 |
| | P1 | 0.6 | | | | | |
| | P2 | | | 1.0 | | | |
| | P3 | | 0.1 | | | | |
| | P4 | | | | 0.6 | | |
| Infiltration Properties | | good | good | good | good | poor | poor |
| α1 (ppm) | | 25 | 25 | 25 | 25 | 25 | 25 |
| Tg (°C) | | 140 | 140 | 140 | 140 | 140 | 140 |

| | | | | | | | |
|---|---|---|---|---|---|---|---|
| EP-1: Bisphenol F epoxy resin, EP-4901E from ADEKA CORPORATION EP-2: Aminophenol epoxy resin, EP-3950S from ADEKA CORPORATION EP-3: Dicyclopentadiene epoxy resin, EP-4088S from ADEKA CORPORATION CYE: Bisphenol cyanate ester resin, LeCy from Lonza Silica: Commercially available silica powder CB1: Carbon black, #750B from Mitsubishi Carbon Black; primary particle size: 22 nm CB2: Carbon black, #30 from Mitsubishi Carbon Black; primary particle size: 30 nm P1: Titanium black, 13M from Mitsubishi Materials Electronic Chemicals; primary particle size: 75 nm P2: Titanium black, 13M-C from Mitsubishi Materials Electronic Chemicals; primary particle size: 97 nm P3: Titanium black, UF8 from Mitsubishi Materials Electronic Chemicals; primary particle size: 20 nm P4: Black shielding pigment, Tipaque Black SG-101 [(Ca,Ti,Mn)O₃] from Ishihara Sangyo; average particle size: 950 nm | | | | | | | |

As shown in Table 1, the curable resin composition of the invention has excellent infiltration properties. In contrast, the resin compositions containing carbon black are inferior in infiltration properties.

### Industrial Applicability

The invention provides a curable resin composition that exhibits excellent infiltration properties and achieves fast curing to produce a highly heat-resistant cured product. Therefore, the curable resin composition is suited for use as an underfill material.

## Claims

1. A curable resin composition comprising (A) a cyanate ester resin, (B) an epoxy resin, (C) a latent curing agent, and (D) an inorganic pigment containing at least one metal selected from titanium, iron, copper, chromium, zirconium, calcium, manganese, and zinc.

2. The curable resin composition according to claim 1, wherein the cyanate ester resin (A) is at least one member selected from the group consisting of a compound represented by formula (1):
[Chem. 1]
N C-O-A¹- Y¹-A²-O-CN (1)
wherein Y¹ represents a divalent hydrocarbon group optionally substituted with a fluorine atom or a cyanate group, -O-, -S-, or a single bond; and A¹ and A² each independently represent a phenylene group optionally substituted with an alkyl group having 1 to 4 carbon atoms,
a compound represented by formula (2): 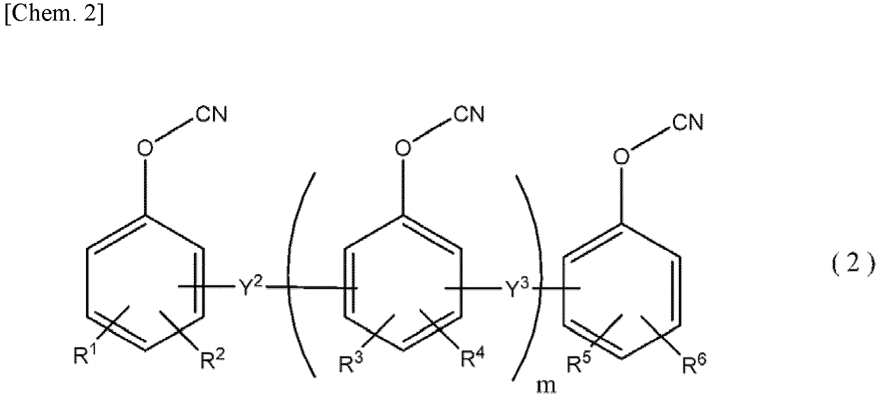 wherein m represents an integer of 1 or greater; Y² and Y³ each independently represent a divalent hydrocarbon group optionally substituted with a fluorine atom or a cyanate group; and R¹, R², R³, R⁴, R⁵, and R⁶ each independently represent a hydrogen atom or an alkyl group having 1 to 4 carbon atoms, and
a prepolymer of the compound represented by formula (1) and/or the compound represented by formula (2).

3. The curable resin composition according to claim 1 or 2, wherein Y¹ in formula (1) and Y² and Y³ in formula (2) is at least one member selected from groups represented by formulae (Y-1) through (Y-9): 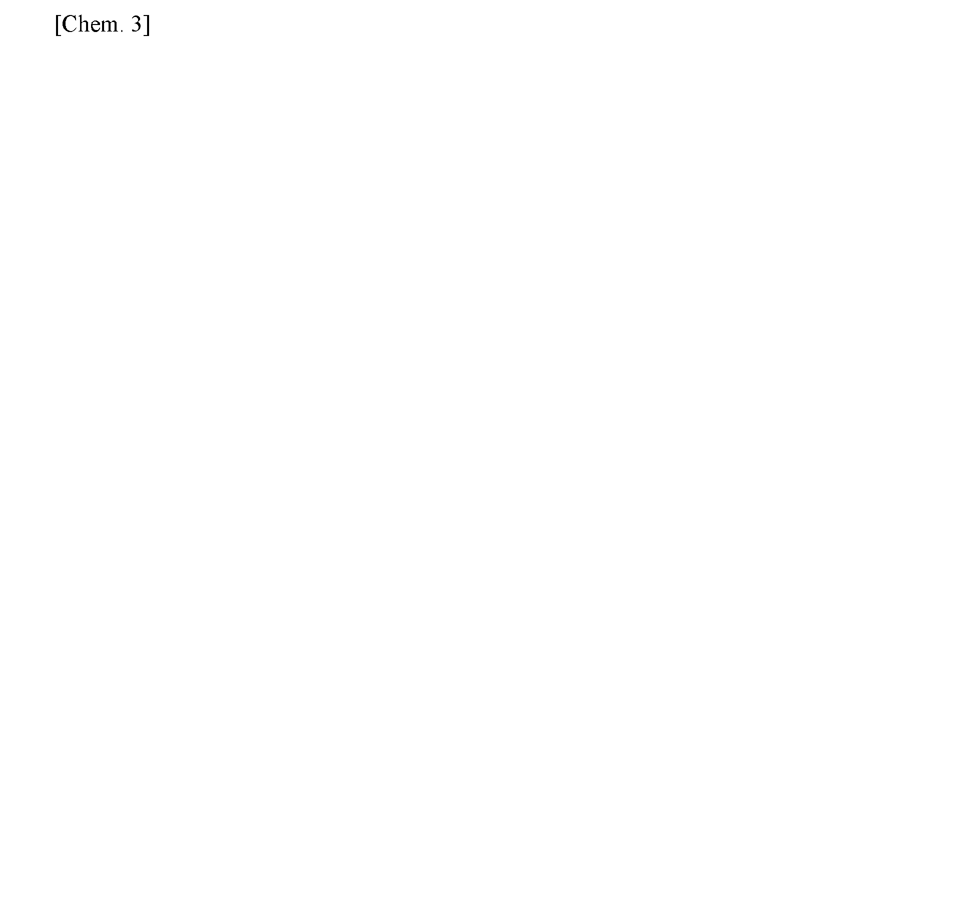 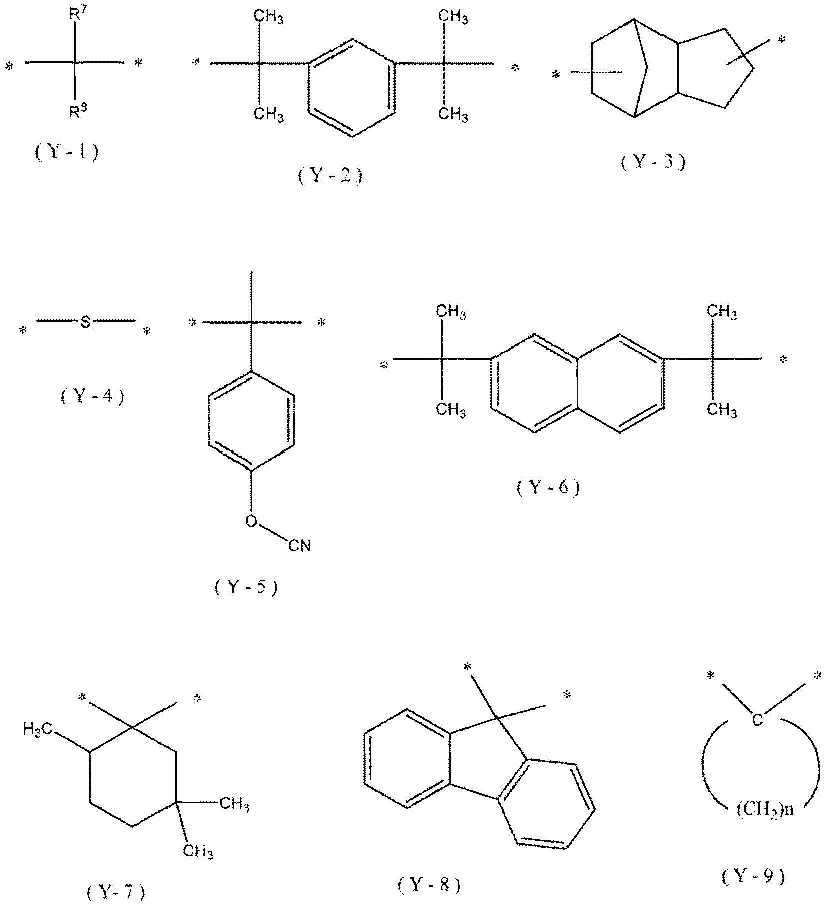 wherein n represents an integer of 4 to 12; R⁷ and R⁸ each independently represent a hydrogen atom or a methyl group optionally substituted with a fluorine atom; and ^{∗} represents a bond.

4. The curable resin composition according to any one of claims 1 to 3, wherein the latent curing agent (C) is an active hydrogen-containing amine compound.

5. The curable resin composition according to claim 4, wherein the active hydrogen-containing amine compound is at least one member selected from (C-1) a modified amine obtained by the reaction between an amine compound having one or more active hydrogens and an epoxy compound, (C-2) a modified amine obtained by the reaction between an amine compound having one or more active hydrogens and an isocyanate compound, (C-3) a modified amine obtained by the reaction between an amine compound having one or more active hydrogens, an epoxy compound, and an isocyanate compound, and (C-4) a latent curing agent containing at least one modified amine selected from (C-1), (C-2), and (C-3) and a phenol resin.

6. The curable resin composition according to any one of claims 1 to 5, wherein the inorganic pigment (D) is titanium black.

7. The curable resin composition according to any one of claims 1 to 6, wherein the inorganic pigment (D) has a primary particle size of 5 to 150 nm.

8. The curable resin composition according to any one of claims 1 to 7, wherein the epoxy resin (B) is present in an amount of 20 to 200 parts by mass per 100 parts by mass of the cyanate ester resin (A).

9. The curable resin composition according to any one of claims 1 to 8, wherein the inorganic pigment (D) is present in an amount of 0.01 to 10 parts by mass per 100 parts by mass of the sum of the cyanate ester resin (A) and the epoxy resin (B).

10. A cured product obtained by curing the curable resin composition according to any one of claims 1 to 9.

11. An underfill material comprising the curable resin composition according to any one of claims 1 to 9.
